# EUROPEAN PATENT SPECIFICATION

(11) **EP 0 412 781 B1**
(45) Date of publication and mention of the grant of the patent: **01.03.1995**
(21) Application number: 90308688.2
(22) Date of filing: 07.08.1990
(51) Int. Cl.: G11C 11/00, G11C 16/04

(54) **Test method for an integrated circuit including non-volatile memory cell capable of temporarily holding information**
Testverfahren für eine integrierte Schaltung mit nichtflüchtiger Speicherzelle fähig zum zeitweiligen Halten von Information
Procédé de test pour un circuit intégré avec cellule de mémoire non volatile pouvant garder temporairement de l'information

(30) Priority: 09.08.1989 JP 206396/89
(43) Date of publication of application: 13.02.1991
(73) Proprietor: KAWASAKI STEEL CORPORATION, Chuo-Ku, Kobe-City Hyogo 651 (JP)
(72) Inventor: Kawana, Keiichi, Chiba-shi, Chiba 280 (JP)
(74) Representative: Stebbing, Timothy Charles

(56) References cited:
- FR-A- 2 300 391
- US-A- 4 030 081
- US-A- 4 788 663
- US-A- 4 829 203

## Description

The present invention relates to a test method for an integrated circuit that includes a non-volatile memory cell capable of temporarily holding information and that is suitable for application to a programmable logic device (PLD).

PLDs sometimes include a non-volatile memory such as a PROM (programmable ROM) capable of erasing/rewriting any data with ultraviolet rays or an electric signal, namely, an EPROM (erasable PROM), an EEPROM (electrically erasable PROM), and the like.

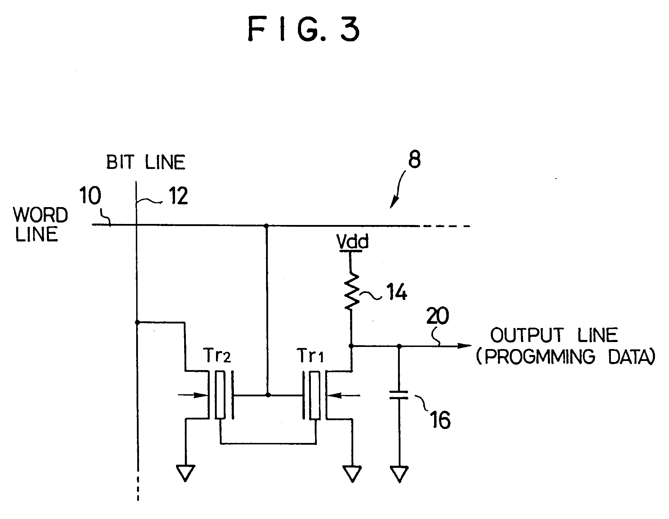

Such a memory cell 8 circuit including an EPROM in a PLD is exemplarily illustrated in Fig. 3.

In the same figure, Tr₁ is a floating gate transistor for holding written information, Tr₂ is a floating gate transistor sharing its gate with the transistor Tr₁, 10 is a word line for selecting a row into and from which any information is written and read out, 12 is a bit line for inputting a write/read signal of any information, 14 is a resistor for supplying therethrough supply voltage Vdd to the transistor Tr₁, 16 is a noise suppressing capacitor which is provided at need, and 20 is an output line for outputting programming data.

For writing any information such as programming data into the memory cell 8, relatively high voltage is applied to the word line 10 and the bit line 12 to inject electric charges into the floating gate of the transistor Tr₂.

Additionally, for reading any information, relatively low read voltage is applied to the word line 10 to cause a change in a current flowing through the writing transistor Tr₂, which change is in turn read through the bit line 12 as the information stored in the transistor Tr₁.

In such an integrated circuit such as a PLD including the prior memory cell, however, it is needed, after writing various information in the memory cell to diagnose (i.e. test) operation of the same upon inspection of the integrated circuit chip, to erase written information in the memory cell by irradiating the chip with ultraviolet rays or inputting an electric signal into the same for each such inspection. Such erasing is time-consuming and requires wasteful operation, e.g. it takes 20 minutes for every inspection of an EPROM. This obstructs mass production in the absence of any countermeasure to solve it.

In view of the drawbacks with the prior art, it is desirable to provide a test method for an integrated circuit in which a non-volatile memory cell included therein can be inspected in a short time with ease.

US-A-4 030 081 discloses an integrated circuit having the features of the preamble of accompanying claim 1. However, this document does not disclose a test method.

According to the present invention, there is provided a test method for an integrated circuit including a non-volatile memory cell capable of temporarily holding information, said integrated circuit comprising:-
a memory cell including a non-volatile memory device for storing desired information;
an ordinary operation word line for controlling the non-volatile memory device during ordinary operation;
an additional word line which is independently provided in addition to said ordinary operation word line;
a switching element which is switched on and off by a potential on said additional word line;
a capacitor connected to an output terminal of said non-volatile memory device; and
means for switching on said switching element when said non-volatile memory device is not operated to accumulate electric charge on said capacitor;
characterised in that said test method comprises using said additional word line as an inspection word line for switching on said switching element as the information is temporarily held on the capacitor and read from the same, whereby the function of the non-volatile memory device is tested by charging the capacitor, temporarily holding the charge on the capacitor, and reading out the charge to test if the charge has changed due to a defect of the non-volatile memory device.

The present inventor made various investigations until now to eliminate much time and operation required for storing information in a non-volatile memory device and reading the information from the same upon inspecting an integrated circuit chip including the non-volatile memory device such as an EPROM and the like. As a result, the inventor realised that a dynamic RAM (DRAM) composed of a transistor and a capacitor, and the like is easy for any information to be written thereinto in a short time, and hence intended to apply the function of such a DRAM to the present case.

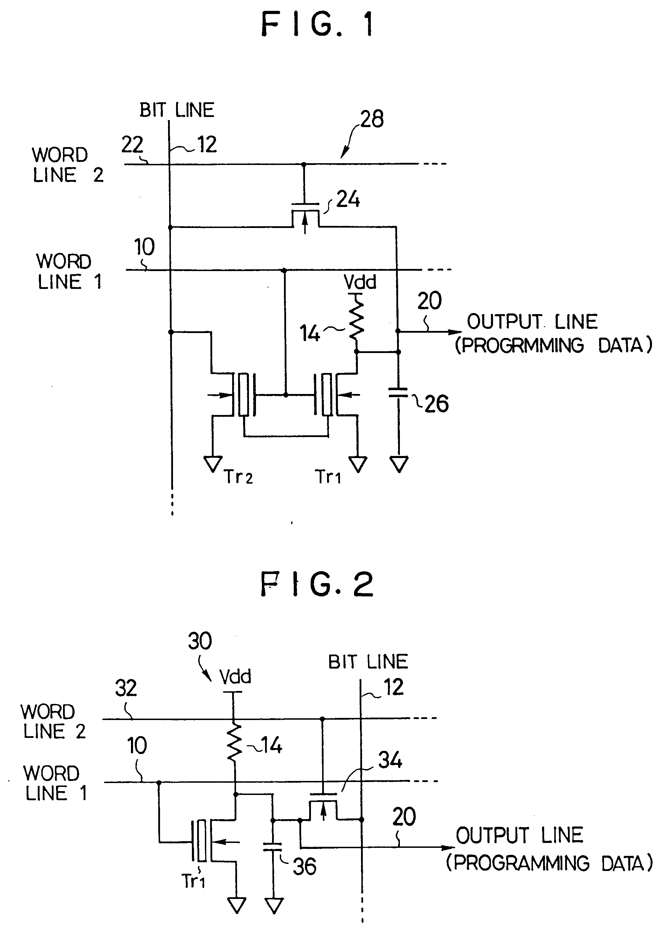

For example, in an EPROM, there is provided the word line 10 for selection of a row and for writing information as shown in Fig. 3, and are provided further, as shown in Fig. 1 for example, an inspection word line 22, a selection transistor 24, and a storage capacitor 26. Upon inspection, a signal is inputted into the word line 22 to switch on the selection transistor 24, whereby desired information such as programming data, etc., is inputted through the bit line 12 and stored in the capacitor 26, and thereafter outputted and read through the output line 20. More specifically, the selection transistor 24 and the capacitor 26 are operated as in a DRAM, so that the function of an integrated circuit chip such as a PLD is diagnosed without operation of a non-volatile memory device. Thus, integrated circuits, each including a non-volatile memory cell can be easily inspected in a short time, and mass-produced.

Herein, the capacitor 26 has a time constant between it and the resistor 14 to keep electric charges for several tens of millisecond and hence permit the function of an integrated circuit to be diagnosed during that time. Additionally, for the capacitor 26 there can be available a capacitor which has previously been provided on the output side of the storage transistor Tr₁ for noise suppression. Thus , effective use of the device is attained to improve the degree of integration.

The preferred embodiments will be described with reference to the drawings, wherein like elements have been denoted throughout the figures with like reference numerals, and wherein:
Fig. 1 is a circuit diagram illustrating the construction of a memory cell of a PLD to which the present invention may be applied;
Fig. 2 is a circuit diagram illustrating the construction of another memory cell of a PLD to which the present invention may be applied; and
Fig. 3 is a circuit diagram illustrating the construction of a prior PLD memory cell.

In what follows, the present invention will be described with reference to the accompanying drawings.

First, a first type of memory cell will be described, to which the present invention may be applied.

In this type of cell, in a PLD for example, there is provided, as illustrated in Fig. 1, a memory cell 28 which includes, in addition to the memory cell 8 shown in Fig. 3, an inspection word line 22, a selection transistor 24, and an information holding capacitor 26 for DRAM operation also serving as a noise suppressing capacitor. Further, additional construction is similar to that of the memory cell 8 of Fig. 3, and hence the like elements will be denoted with the like reference numeral and the description thereof will be omitted.

For inspection of a PLD including the memory cell 28 according to the first embodiment, a signal is first applied to the word line 22 to switch on the selection transistor 24. Then, a signal voltage is inputted through the bit line 12 to store programming data on the capacitor 26. At this time, the first word line 10 is made off (no signal is inputted) to prevent the transistor Tr₁ from being read.

In succession, the data written in the capacitor 16 is read through the output line 20 with the same operation as in the DRAM. The capacitor 16 can store electric charges over several tens of millisecond for example, owing to time constant defined with it and the resistor 14, permitting the function of the memory cell to be diagnosed during that time. For the resistor 16, ones of from several hundreds of gigaohm (GΩ) to several teraohm (TΩ) are available, which increases the time constant RC to reduce the leakage of the electric charges and assure increased read time.

In the following, a second type of memory cell will be described, to which the present invention may also be applied.

In the second type of cell, in a PLD for example, there is provided, as illustrated in Fig. 2, a memory cell 30 which includes, in addition to a floating gate transistor Tr₁, for holding written information, a word line 10 for selecting a row where any information is written and read, a bit line 12 for inputting a write/read signal of any information, and a resistor 14 through which supply voltage Vdd is applied to the transistor Tr₁, an inspection word line 32, a selection transistor 34, and an information holding capacitor 36 for DRAM operation also serving as a noise suppressing capacitor.

For inspecting a PLD chip including the memory cell 30, as in the first type of cell, the selection transistor 34 and the capacitor 36 are operable as in the DRAM, and any information is written and read respectively through the bit line 12 and the output line 20 to diagnose.

Also in the second type of cell, a PLD can be inspected without the need writing and reading any information into and from the transistor Tr₁, and hence without requiring much time and elaborate operation for the inspection.

Although the memory cells of circuit construction shown in Figs. 1 and 2 were exemplarily illustrated, circuit construction for applying the present invention is not limited thereto. For example, the invention may be applicable to an integrated circuit including an EEPROM as a non-volatile memory.

## Claims

1. A test method for an integrated circuit including a non-volatile memory cell capable of temporarily holding information, said integrated circuit comprising:-
a memory cell (28, 30) including a non-volatile memory device for storing desired information;
an ordinary operation word line (10) for controlling the non-volatile memory device during ordinary operation;
an additional word line (22, 32) which is independently provided in addition to said ordinary operation word line;
a switching element (24, 34) which is switched on and off by a potential on said additional word line;
a capacitor (26, 36) connected to an output terminal of said non-volatile memory device; and
means for switching on said switching element when said non-volatile memory device is not operated to accumulate electric charge on said capacitor;
characterised in that said test method comprises using said additional word line as an inspection word line (22, 32) for switching on said switching element (24, 34) as the information is temporarily held on the capacitor (26, 36) and read from the same, whereby the function of the non-volatile memory device is tested by charging the capacitor, temporarily holding the charge on the capacitor, and reading out the charge to test if the charge has changed due to a defect of the non-volatile memory device.

2. A test method according to claim 1, wherein said non-volatile memory device is interrupted in its operation during its temporarily holding any information by a signal on said ordinary operation word line (10).

## Patentansprüche

1. Prüfverfahren für eine integrierte Schaltung, enthaltend eine nichtflüchtige Speicherzelle, die zeitweilig Information speichern kann, wobei die integrierte Schaltung umfaßt
eine Speicherzelle (28, 30), die eine nichtflüchtige Speichereinrichtung enthält, geeignet zum Speichern gewünschter Information,
eine Wortleitung (10) für Normalbetrieb, geeignet zum Steuern der nichtflüchtigen Speichereinrichtung während des Normalbetriebs,
eine zusätzliche Wortleitung (22, 32), die unabhängig und zusätzlich zur Wortleitung für Normalbetrieb bereitgestellt wird,
ein Schaltbauteil (24, 34), das von einem Potential auf der zusätzlichen Wortleitung ein- und ausgeschaltet wird, einen Kondensator (26, 36), der an einen Ausgangsanschluß der nichtflüchtigen Speichereinrichtung angeschlossen ist, und
eine Vorrichtung zum Schalten auf dem Schaltbauteil, wenn die nichtflüchtige Speichereinrichtung nicht betrieben wird, um elektrische Ladungen auf dem Kondensator zu sammeln, dadurch gekennzeichnet,
daß das Prüfverfahren umfaßt den Gebrauch der zusätzlichen Wortleitung als Inspektions-Wortleitung (22, 32), geeignet zum Schalten auf dem Schaltbauteil (24, 34), wenn die Information zeitweilig auf dem Kondensator (26, 36) gehalten und von ihm gelesen wird, wobei die Funktion der nichtflüchtigen Speichereinrichtung geprüft wird durch Laden des Kondensators, zeitweiliges Halten der Ladung auf dem Kondensator und Auslesen der Ladung, um festzustellen, ob sich die Ladung aufgrund eines Schadens in der nichtflüchtigen Speichereinrichtung verändert hat.

2. Prüfverfahren nach Anspruch 1, wobei ein Signal auf der Normalbetriebs-Wortleitung (10) die nichtflüchtige Speichereinrichtung in ihrem Betrieb unterbricht, während sie zeitweilig irgendeine Information hält.

## Revendications

1. Méthode de test pour un circuit intégré comportant une cellule de mémoire non volatile pouvant garder temporairement de l'information, ledit circuit intégré comprenant:-
une cellule de mémoire (28, 30) contenant un dispositif de mémoire non volatile pour stocker l'information désirée;
une ligne de mot d'opération normale (10) pour commander le dispositif de mémoire non volatile pendant une opération normale;
une ligne de mot additionnelle (22, 32) prévue indépendamment en plus de ladite ligne de mot d'opération normale;
un élément interrupteur (24, 34) qui est fermé et ouvert par un potentiel sur ladite ligne de mot additionnelle;
un condensateur (26, 36) connecté à une borne de sortie dudit dispositif de mémoire non volatile; et des moyens pour fermer ledit élément interrupteur lorsque ledit dispositif de mémoire non volatile ne fonctionne pas pour accumuler une charge électrique sur ledit condensateur;
caractérisée en ce que ledit procédé de test utilise ladite ligne de mot additionnelle en tant que ligne de mot de vérification (22, 32) pour fermer ledit élément interrupteur (24, 34) alors que l'information est gardée temporairement par le condensateur (26, 36) et lue à partir de lui, le fonctionnement du dispositif de mémoire non volatile étant testé en chargeant le condensateur, en maintenant temporairement la charge sur le condensateur et en lisant la charge pour tester si la charge a changé à cause d'un défaut du dispositif de mémoire non volatile.

2. Procédé de test selon la revendication 1, selon lequel le fonctionnement du dispositif de mémoire non volatile est interrompu pendant son maintien temporaire d'une quelconque information par un signal sur ladite ligne de mot d'opération normale (10).
